# EUROPEAN PATENT APPLICATION

(11) **EP 4 369 389 A1**
(43) Date of publication of application: **15.05.2024**
(21) Application number: 23194205.3
(22) Date of filing: 30.08.2023
(51) Int. Cl.: H01L 23/15, H01L 23/498

(54) **HIGH ASPECT RATIO TGV SUBSTRATES THROUGH DIRECT HYBRID BONDING OF THIN TGV SUBSTRATES**

(30) Priority: 08.11.2022 US 202217983230
(71) Applicant: Intel Corporation, Santa Clara, CA 95054 (US)
(72) Inventor: ANGOUA, Bainye, Phoenix, 85045 (US); BRYKS, Whitney, Tempe, 85284 (US); KORNBLUTH, Yosef, Phoenix, 85014 (US); ROSALES-YEOMANS, Daniel, Gilbert, 85297 (US); CLINGAN, Holly, Chandler, 85226 (US); QUACH, Patrick, Chandler, 85286 (US); LEWIS, Jade, Phoenix, 85042 (US); CANDADAI, Aaditya, Chandler, 85226 (US)
(74) Representative: Goddar, Heinz J.

(57) **Abstract**

Embodiments disclose a package substrate. In an embodiment, the package substrate comprises a core, where the core comprises: a first sub-core, where the first sub-core comprises a glass and a first through glass via (TGV), and a second sub-core, where the second sub-core comprises the glass and a second TGV. In an embodiment, the first TGV directly contacts the second TGV.

## Description

### TECHNICAL FIELD

Embodiments of the present disclosure relate to electronic packages, and more particularly to package substrates with glass cores that include high aspect ratio through glass vias (TGVs) through multiple sub-core layers.

### BACKGROUND

Advanced packaging architectures are moving towards the use of glass materials for the core. In order to provide through glass vias (TGVs), a laser assisted etching process is used. The laser assisted etching process includes a laser exposure of the glass. The laser exposure alters a microstructure and/or phase of the glass and renders the exposed areas more susceptible to an etching chemistry. After the laser exposure, the wet etch is performed to form via openings. Such laser assisted etching processes are generally suitable for TGVs that have a low aspect ratio (e.g., height:width). For example, aspect ratios up to approximately 5:1 may be formed with a laser assisted etching process.

However, at higher aspect ratios, the formation of the TGVs is made more difficult. For example, the formation of a seed layer can no longer be done with a sputtering process. Instead an atomic layer deposition (ALD) process may be needed. Additionally, the plating process is slower. This leads to a decreased throughput. Ultimately, it has been demonstrated that aspect ratios above 5:1 are not capable of being formed in high volume manufacturing (HVM) architectures. This is particularly problematic when thicker cores are needed (e.g., greater than approximately 200µm).

### BRIEF DESCRIPTION OF THE DRAWINGS

Figure 1 is a cross-sectional illustration of a glass core with three sub-core layers with through glass vias (TGVs) that include stacked portions, in accordance with an embodiment.
Figure 2 is a cross-sectional illustration of a glass core with three sub-core layers with TGVs that include stacked portions with tapered sidewalls, in accordance with an embodiment.
Figure 3 is a cross-sectional illustration of a glass core with three sub-core layers with TGVs that include stacked portions with hourglass shaped cross-sections, in accordance with an embodiment.
Figure 4 is a cross-sectional illustration of a package substrate with a glass core that includes sub-core layers with TGVs that include stacked portions, in accordance with an embodiment.
Figure 5A is a cross-sectional illustration of a glass sub-core layer, in accordance with an embodiment.
Figure 5B is a cross-sectional illustration of the glass sub-core layer after via openings are formed through the sub-core layer, in accordance with an embodiment.
Figure 5C is a cross-sectional illustration of the glass sub-core layer after a seed layer is applied, in accordance with an embodiment.
Figure SD is a cross-sectional illustration of the glass sub-core layer after a conductive layer is plated over the seed layer, in accordance with an embodiment.
Figure 5E is a cross-sectional illustration of the glass sub-core after the conductive layer is recessed to isolate TGV portions in the via openings, in accordance with an embodiment.
Figure 5F is a plan view illustration of the glass sub-core that illustrates a plurality of TGV portions and fiducial marks, in accordance with an embodiment.
Figure 5G is a cross-sectional illustration of a pair of glass sub-core layers being brought together with a hybrid bonding process, in accordance with an embodiment.
Figure SH is a cross-sectional illustration of the pair of glass sub-core layers after hybrid bonding, where the TGV portions are slightly misaligned, in accordance with an embodiment.
Figure 5I is a cross-sectional illustration of a third glass sub-core layer being attached to the pair of glass sub-core layers with a hybrid bonding process, in accordance with an embodiment.
Figure 5J is a cross-sectional illustration of a glass core with a set of three sub-core layers that are used to form TGVs with three stacked portions, in accordance with an embodiment.
Figure 5K is a cross-sectional illustration of the glass core after edges of the glass core are polished to provide a smooth edge without any protrusions, in accordance with an embodiment.
Figure 6 is a zoomed in illustration of the interface between a first portion of a TGV and a second portion of a TGV, in accordance with an embodiment.
Figure 7 is a cross-sectional illustration of an electronic system with a package substrate that includes a glass core with a plurality of sub-core layers, in accordance with an embodiment.
Figure 8 is a schematic of a computing device built in accordance with an embodiment.

### EMBODIMENTS OF THE PRESENT DISCLOSURE

Described herein are package substrates with glass cores that include high aspect ratio through glass vias (TGVs) through multiple sub-core layers, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

As noted above, glass core architectures for package substrates are becoming more popular in electronic packaging applications. Particularly, the dimensional stability of glass cores and the ability to use laser induced deep etching technologies enable tighter through hole pitch and smaller diameters. However, the use of glass cores is not without issue. Particularly, the laser induced deep etching process is limited in the form factor of the through glass vias (TGVs). For example, existing technologies are generally limited to aspect ratios (height:width) up to approximately 5:1. This is due to several factors. One issue is that higher aspect ratios require more severe tapering of the sidewalls, which can result in TGVs that are too narrow. Additionally, the seed layer formation and plating processes are made more difficult. Instead of using a physical vapor deposition (PVD) seed layer deposition process, a more expensive and complex atomic layer deposition (ALD) process may be needed. Additionally, the plating chemistry can be more complex and require a longer plating duration.

Accordingly, embodiments disclosed herein include glass cores that are formed with a plurality of glass sub-cores. The glass sub-cores are a thickness that allows for low aspect ratio TGVs to be formed. The glass sub-cores can then be stacked with the low aspect ratio TGVs contacting each other to form higher aspect ratio features. That is, high aspect ratio (e.g., 5:1 or greater, 10:1 or greater, or 15:1 or greater) features can be formed by stacking multiple lower aspect ratio features. The low aspect ratio features can be formed with conventional via formation processes (e.g., standard laser assisted etching and PVD seed layer plating).

In some embodiments, the glass sub-cores may be stacked together using a hybrid bonding process. A hybrid bonding process refers to the process of bonding together structures with at least two different types of interfaces. In the case of glass sub-cores, the glass material may bond together and the conductive vias may bond together. That is, the hybrid bond may include a glass-to-glass interface and a copper-to-copper interface. In an embodiment, the hybrid bonding process may result in a visible seam at the copper-to-copper interface. Particularly, a grain direction in a first via may be different than a grain direction in a second via. The dissimilar grain directions may be evident when analyzing the interface with one or more different microscopy tools. In some instances a seam may also be visible at the glass-to-glass interface. Though, in other embodiments, the glass-to-glass interface may be seamless, and the glass core may appear to be formed from a single monolithic structure.

It is to be appreciated that there are several ways to identify that such a glass sub-core stacking process was used to fabricate a glass core. One residual processing artifact is that the TGV portions may be slightly offset from each other. That is, a centerline of a first TGV portion may be offset from a centerline of a second TGV portion. For example, the offset may be up to approximately 2µm. As used herein, "approximately" refers to a range of values within ten percent of the stated value. For example, approximately 2µm may refer to a range between 1.8µm and 2.2µm. Additionally, due to an edge polishing process, the sidewall of a first TGV portion may be a first distance to the edge of the glass core, and the sidewall of a second TGV portion may be a second distance to the edge of the glass core that is different than the first distance.

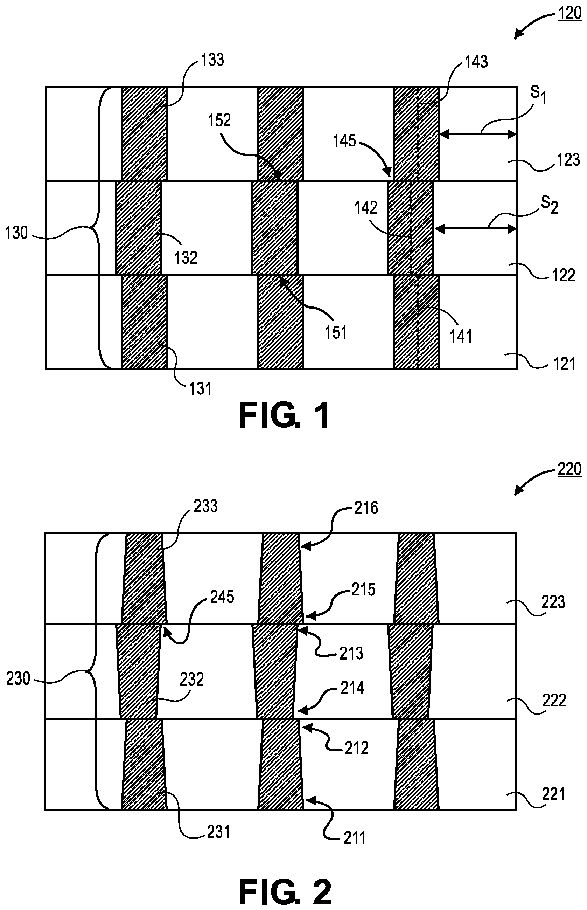

Referring now to Figure 1, a cross-sectional illustration of a glass core 120 is shown, in accordance with an embodiment. In an embodiment, the glass core 120 may comprise a plurality of sub-core layers 121, 122, and 123. The sub-core layers 121, 122, and 123 may be glass layers. The glass material may be any suitable glass material, such as, for example, borosilicate glass, fused silica glass, or the like. The sub-core layers 121, 122, and 123 may be substantially the same thickness. Though in other embodiments, two or more of the sub-core layers 121, 122, and 123 may have different thicknesses. For example, the thicknesses of the sub-core layers 121, 122, and 123 may be approximately 500µm or less. In a particular embodiment, the sub-core layers 121, 122, and 123 may be approximately 200µm thick. While three sub-core layers 121, 122, and 123 are shown in Figure 1, it is to be appreciated that the core 120 may include two or more sub-core layers.

In an embodiment, each sub-core layer 121, 122, and 123 may comprise TGV portions. For example, TGV portions 131 are provided in sub-core layer 121, TGV portions 132 are provided in sub-core layer 122, and TGV portions 133 are provided in sub-core layer 123. In an embodiment, the TGV portions 131, 132, and 133 may have an aspect ratio (height:width) that is approximately 5:1 or less. For example, in the case of 200µm thick sub-core layers 121, 122, and 123, the height of the TGV portions 131, 132, and 133 may be approximately 200µm, and the width of the TGV portions 131, 132, and 133 may be approximately 40µm. The TGV portions 131, 132, and 133 may be stacked over each other in order to form a TGV 130 through the core 120. The stacking allows for high aspect ratio features to be formed. For example, the aspect ratio of the TGV 130 may be approximately 10:1 or greater, or approximately 15:1 or greater.

The TGV 130 may also have visible interfaces 151 and 152 between the TGV portions 131, 132, and 133. The interfaces 151 and 152 may be visible using certain microscopy techniques. Particularly, the interfaces 151 and 152 may demonstrate non-uniform grain directions. For example, the grain direction of TGV portion 131 may be different than the grain direction of TGV portion 132. Therefore, there may be a discontinuous grain direction at the interface 151.

As shown, the TGV 130 has a distinctive shape that is attributable to the stacking process used to form the core 120. Particularly, the individual TGV portions 131, 132, and 133 may be somewhat misaligned from each other. For example, centerlines 141, 142, and 143 may be offset from each other. In a particular embodiment, the offset may be up to approximately 2µm between each layer. This offset is due to inherent registration limits between layers. As shown, the offset structure may result in steps 145 that are present at the interfaces. For example, the top surface of TGV portion 132 may be partially exposed to form step 145.

The offset of the TGV portions 131, 132, and 133 may also be demonstrated by a spacing S from the edge of the glass core 120. For example, TGV portion 133 may have a spacing Si to the edge of the glass core 120, and TGV portion 132 may have a spacing S₂ to the edge of the glass core 120. The spacing S₂ may be different than the spacing Si. The non-uniform spacing may be the result of an edge polishing process described in greater detail below. Generally, the stacking of sub-core layers 121, 122, and 123 may result in offset edges. The offset edges are then polished back to provide a single planar edge. Since the different sub-core layers 121, 122, and 123 are polished different amounts, the spacings (e.g., Si and S₂) are different.

Referring now to Figure 2, a cross-sectional illustration of a core 220 is shown, in accordance with an additional embodiment. The core 220 may comprise a plurality of sub-core layers 221, 222, and 223. The sub-core layers 221, 222, and 223 may include glass materials similar to glass substrates described above. The thickness of each of the sub-core layers 221, 222, and 223 may be up to approximately 500µm in some embodiments.

In an embodiment TGVs 230 may pass through a thickness of the core 220. The TGVs 230 may have an aspect ratio of approximately 10:1 or greater, or approximately 15:1 or greater. The TGVs 230 may comprise a plurality of TGV portions 231, 232, and 233 that are stacked on each other. The TGV portions 231, 232, and 233 may have aspect ratios up to approximately 5:1. In an embodiment, the TGV portions 231, 232, and 233 may have tapered sidewalls. For example, the TGV portion 231 has a wide end 211 and a narrow end 212, the TGV portion 232 has a wide end 213 and a narrow end 214, and the TGV portion 233 has a wide end 215 and a narrow end 216. In an embodiment, the TGV portions 231, 232, and 233 are stacked in an orientation so that wide ends interface with each other and narrow ends interface with each other. For example, wide end 215 interfaces with wide end 213, and narrow end 214 interfaces with narrow end 212. Matching wide end to wide end and narrow end to narrow end allows for improved hybrid bonding between the sub-core layers 221, 222, and 223.

Similar to the embodiment described in greater detail above, the TGV portions 231, 232, and 233 may have some degree of offset from each other. That is, centerlines (not shown in Figure 2) of each of the TGV portions 231, 232, and 233 may be offset from each other. In an embodiment, the offset of the centerlines may be approximately 2µm or less. This offset may result in the formation of steps 245 and the like at the edges of the TGV portions 231, 232, and 233.

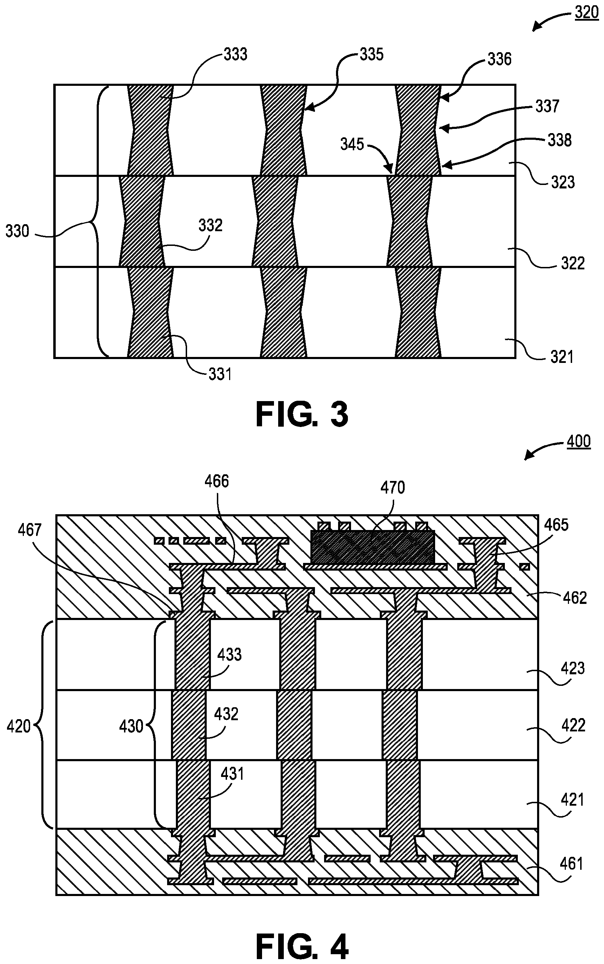

Referring now to Figure 3, a cross-sectional illustration of a core 320 is shown, in accordance with an additional embodiment. The core 320 may comprise a plurality of sub-core layers 321, 322, and 323. The sub-core layers 321, 322, and 323 may include glass materials similar to glass substrates described above. The thickness of each of the sub-core layers 321, 322, and 323 may be up to approximately 500µm in some embodiments.

In an embodiment, the core 320 may comprise TGVs 330. The TGVs 330 may have an aspect ratio of approximately 10:1 or greater, or approximately 15:1 or greater. In an embodiment, the TGVs 330 may comprise a plurality of TGV portions 331, 332, and 333. In an embodiment, each of the TGV portions 331, 332, and 333 may have sidewalls 335 that are tapered. In a particular embodiment, the TGV portions 331, 332, and 333 have an hourglass shaped cross-section. As used herein, an hourglass shaped cross-section may refer to a shape that has wider ends (e.g., ends 338 and 336) and a narrower middle (e.g., middle 337). The formation of an hourglass shaped TGV portion 331, 332, and 333 may be the result of a dual sided laser assisted patterning process. The TGV portions 331, 332, and 333 may have aspect ratios up to approximately 5:1.

In an embodiment, the TGV portions 331, 332, and 333 may be slightly misaligned with each other. For example, centerlines (not shown in Figure 3) of each of the TGV portions 331, 332, and 333 may be offset from each other by up to approximately 2µm. The offset nature of the TGV portions 331, 332, and 333 may result in steps 345 or the like being formed in the TGV 330.

Referring now to Figure 4, a cross-sectional illustration of a package substrate 400 is shown, in accordance with an embodiment. In an embodiment, the package substrate 400 comprises a glass core 420. The glass core 420 may be fabricated from a plurality of glass sub-core layers 421, 422, and 423 that are stacked on each other. In an embodiment, the glass sub-core layers 421, 422, and 423 may each have a thickness up to approximately 500µm.

In an embodiment, TGVs 430 are provided through the glass core 420. The TGVs 430 may be high aspect ratio features. For example, the TGVs 430 may have an aspect ratio of approximately 10:1 or greater, or approximately 15:1 or greater. The TGVs 430 may be fabricated from a plurality of TGV portions 431, 432, and 433. The TGV portions 431, 432, and 433 may have aspect ratios up to approximately 5:1. In the illustrated embodiment, the TGV portions 431, 432, and 433 have vertical sidewalls. Though it is to be appreciated that TGV portions 431, 432, and 433 may have tapered sidewalls (e.g., similar to Figure 2) or hourglass shaped cross-sections (e.g., similar to Figure 3). As shown, the alignment of the TGV portions 431, 432, and 433 may not be perfect, and there may be some degree of offset between each TGV portion 431, 432, and 433.

In an embodiment, the package substrate 400 may further comprise buildup layers 461 and 462 above and below the glass core 420. The buildup layers 461 and 462 may be dielectric material, such as buildup film or the like. In an embodiment, conductive features (e.g., traces 466, vias 465, pads 467, and the like) may be provided in the buildup layers 461 and 462. In some embodiments, one or more bridge dies 470 may be provided in the buildup layer 462. The bridge die 470 may include high density routing in order to communicatively couple together a pair of dies (not shown in Figure 4) that are mounted to the package substrate 400.

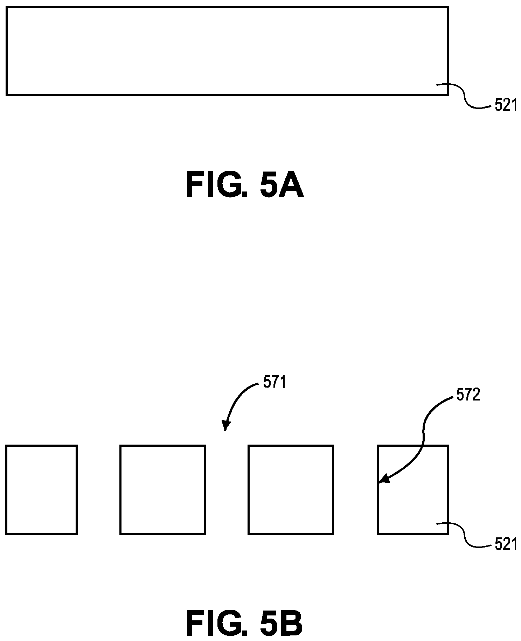

Referring now to Figures 5A-5K, a series of illustrations depicting a process for assembling a glass core with a plurality of sub-core layers is shown, in accordance with an embodiment. In the illustrated embodiment, the glass core is similar to the glass core 120 in Figure 1. Though, it is to be appreciated that similar processing operations may be used in order to form a glass core similar to those shown in Figure 2 or Figure 3. Particularly, the via openings would be formed with different tapers of the sidewalls.

Referring now to Figure 5A, a cross-sectional illustration of a sub-core layer 521 is shown, in accordance with an embodiment. In an embodiment, the sub-core layer 521 may comprise a glass substrate. In an embodiment, the sub-core layer 521 may have a thickness that is up to approximately 500µm.

Referring now to Figure 5B, a cross-sectional illustration of the sub-core layer 521 after via openings 571 are formed through the sub-core layer 521 is shown, in accordance with an embodiment. In an embodiment, the via openings 571 may be formed with a laser assisted patterning process. Particularly, the sub-core layer 521 is exposed to a laser where the via openings 571 are desired. The laser exposure alters a microstructure and/or phase of the glass sub-core layer 521. The modified regions can then be removed with a wet etching chemistry. In the illustrated embodiment the sidewalls 572 of the via openings 571 are substantially vertical. Though, it is to be appreciated that the sidewalls 572 may be tapered or result in an hourglass shaped via opening 571. In an embodiment, an aspect ratio of the via openings 571 may be up to 5:1.

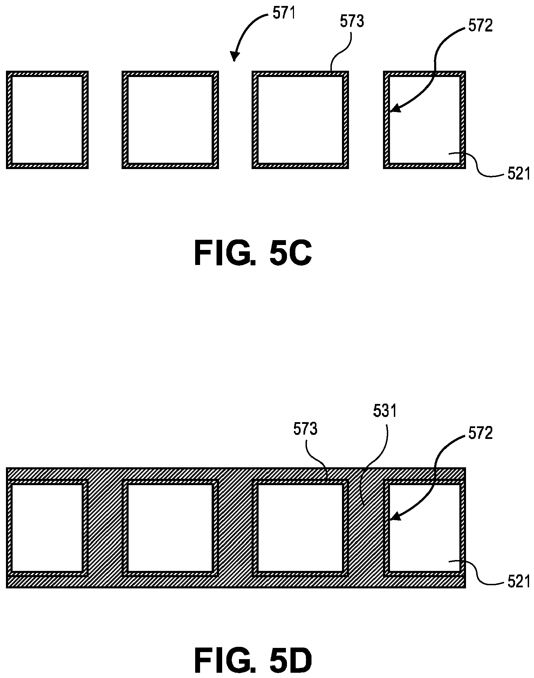

Referring now to Figure 5C, a cross-sectional illustration of the sub-core layer 521 after a seed layer 573 is formed is shown, in accordance with an embodiment. In an embodiment, the seed layer 573 may comprise copper and/or titanium. The seed layer 573 may have a thickness of less than 1µm in some embodiments. Due to the low aspect ratio, the seed layer 573 may be formed with traditional plating process. For example, a PVD process, a sputtering process, or the like may be used to form the seed layer 573. That is, a more expensive and time consuming ALD process is not needed in embodiments disclosed herein. In an embodiment, the seed layer 573 is deposited over the top and bottom surfaces of the sub-core layer 521 and over the sidewalls 572 of the via opening 571.

Referring now to Figure 5D, a cross-sectional illustration of the sub-core layer 521 after a plating process is implemented is shown, in accordance with an embodiment. In an embodiment, the plating process may be an electrolytic plating process. The plating process results in the formation of TGV portions 531 in the via openings 571. For example, the TGV portions 531 may comprise copper or another electrically conductive material or materials. The plating process may also result in the formation of conductive material over the top and bottom surfaces of the sub-core layer 521.

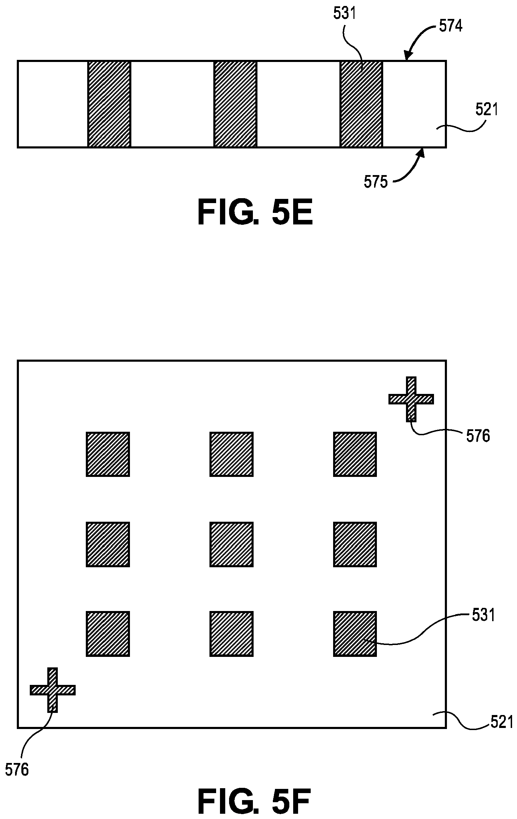

Referring now to Figure 5E, a cross-sectional illustration of the sub-core layer 521 after a polishing operation is shown, in accordance with an embodiment. In an embodiment, the excess conductive material over the top and bottom of the sub-core layer 521 is removed with the polishing operation (e.g., a chemical mechanical polishing (CMP) operation). In an embodiment, the polishing process exposes the top surface 574 and the bottom surface 575 of the sub-core layer 521. Additionally, the TGV portions 531 are electrically isolated from each other. The polishing process may also remove the seed layer 573. While not shown in Figure 5E, it is to be appreciated that the seed layer may persist on the outer surfaces of the TGV portions 531.

Referring now to Figure 5F, a plan view illustration of the sub-core layer 521 is shown, in accordance with an embodiment. As shown, the sub-core layer 521 may further comprise one or more fiducial structures 576. The fiducial structures 576 may be used in order to align sub-core layers together. For example, cross-shaped fiducial markers are shown in Figure 5F. However, it is to be appreciated that any fiducial architecture may be used in embodiments described herein.

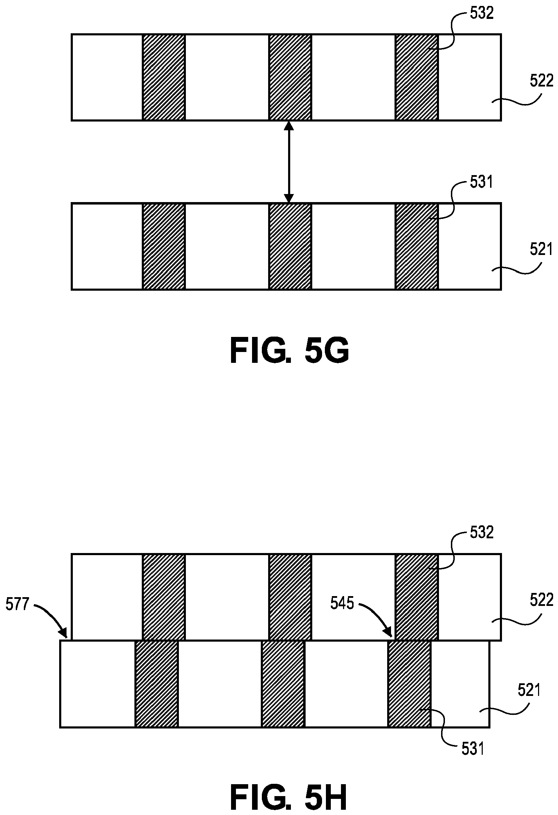

Referring now to Figure 5G, a cross-sectional illustration of a hybrid bonding process in order to bond a sub-core layer 521 to a sub-core layer 522 is shown, in accordance with an embodiment. The sub-core layer 522 with TGV portions 532 may be formed with substantially the same processing operations used to form the sub-core layer 521. In an embodiment, the surfaces of the sub-core layers 521 and 522 may be cleaned and activated with a plasma process before bonding the two sub-core layers 521 and 522 together. In an embodiment, the hybrid bonding process may be a relatively low temperature bonding process. For example, the temperature may be maintained at approximately 400 degrees Celsius or below.

Referring now to Figure 5H, a cross-sectional illustration of the sub-core layer 521 bonded to the sub-core layer 522 is shown, in accordance with an embodiment. As shown, there may be a degree of offset between the TGV portions 531 and 532. For example, centerlines of the TGV portions 531 and 532 may be offset from each other by up to approximately 2µm. For example, steps 545 may be present at the interfaces between the TGV portions 531 and 532. Additionally, the edges of the sub-core layers 521 and 522 may have an offset from each other due to inherent misalignment in the assembly process. The offset may result in the formation of a step 577.

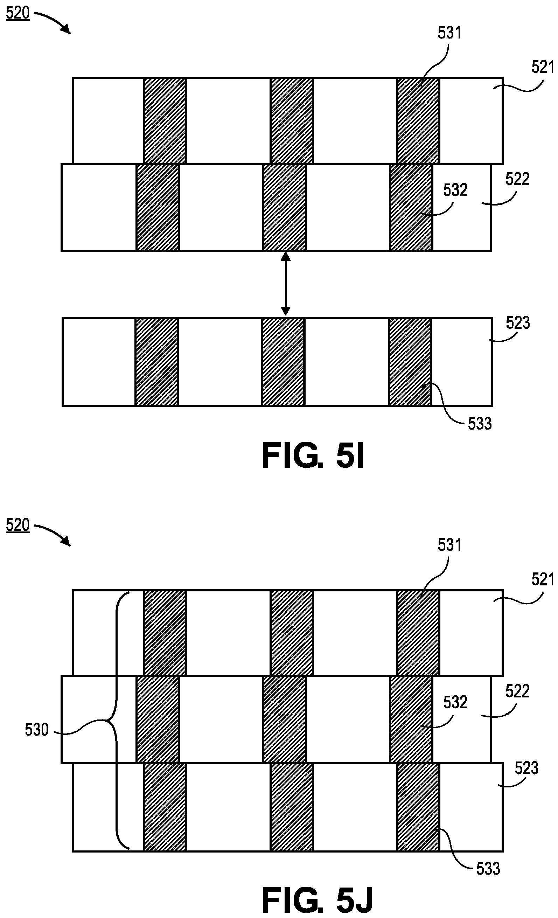

Referring now to Figure 5I, a cross-sectional illustration of a hybrid bonding process in order to bond sub-core layer 523 with TGV portions 533 to the sub-core layer 522 is shown, in accordance with an embodiment. The sub-core layer 523 with TGV portions 533 may be formed with substantially the same processing operations used to form the sub-core layer 521. In an embodiment, the surfaces of the sub-core layers 522 and 523 may be cleaned and activated with a plasma process before bonding the two sub-core layers 522 and 523 together. In an embodiment, the hybrid bonding process may be a relatively low temperature bonding process. For example, the temperature may be maintained at approximately 400 degrees Celsius or below.

Referring now to Figure 5J, a cross-sectional illustration of the core 520 is shown, in accordance with an embodiment. As shown, the TGVs 530 may be formed from the bonding of TGV portions 531, 532, and 533. The TGVs 530 may have aspect ratios of approximately 10:1 or greater, or approximately 15:1 or greater. The TGVs 530 may be characterized by offset TGV portions 531, 532, and 533. That is, centerlines of the TGV portions 531, 532, and 533 may be offset from each other. Additionally, the sidewalls of the sub-core layers 521, 522, and 523 may be offset from each other.

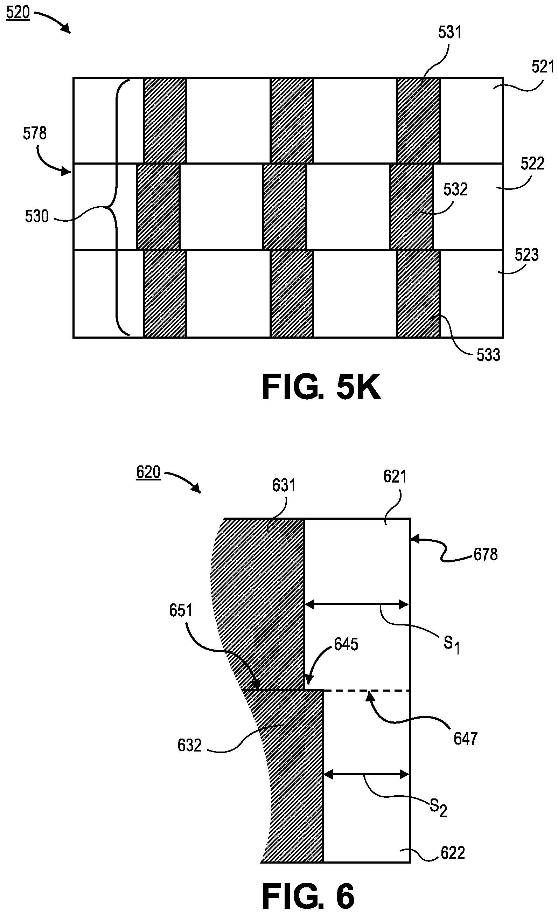

Referring now to Figure 5K, a cross-sectional illustration of the core 520 after an edge polishing process is shown, in accordance with an embodiment. In an embodiment, the edge polishing process may result in the edges 578 of the sub-core layers 521, 522, and 523 being made substantially coplanar with each other. This provides improved handling of the core 520 by assembly tools.

Referring now to Figure 6, a zoomed in illustration showing the interface between a first TGV portions 631 and a second TGV portion 632 in a core 620 is shown, in accordance with an embodiment. As shown, a distinct seam 651 may be provided between the first TGV portion 631 and the second TGV portion 632. The seam 651 may be identified by the discontinuous grain structure between the first TGV portion 631 and the second TGV portion 632. For example, the first TGV portion 631 may have a first grain direction, and the second TGV portion 632 may have a second grain direction that is different than the first grain direction. In an embodiment, an offset between the first TGV portion 631 and the second TGV portion 632 may result in the formation of a step 645 at the interface 651. The offset may also result in a first spacing Si between the first TGV portion 631 and the edge 678 of the core 620 that is different than a second spacing S₂ between the second TGV portion 632 and the edge 678 of the core 620.

In Figure 6, a dashed line 647 is shown. The dashed line 647 indicates the boundary between the first sub-core layer 621 and the second sub-core layer 622. A dashed line is used to indicate that there may not be a visible seam between the first sub-core layer 621 and the second sub-core layer 622. That is, in ideal hybrid bonding architectures, the glass-to-glass bond may result in a seamless interface.

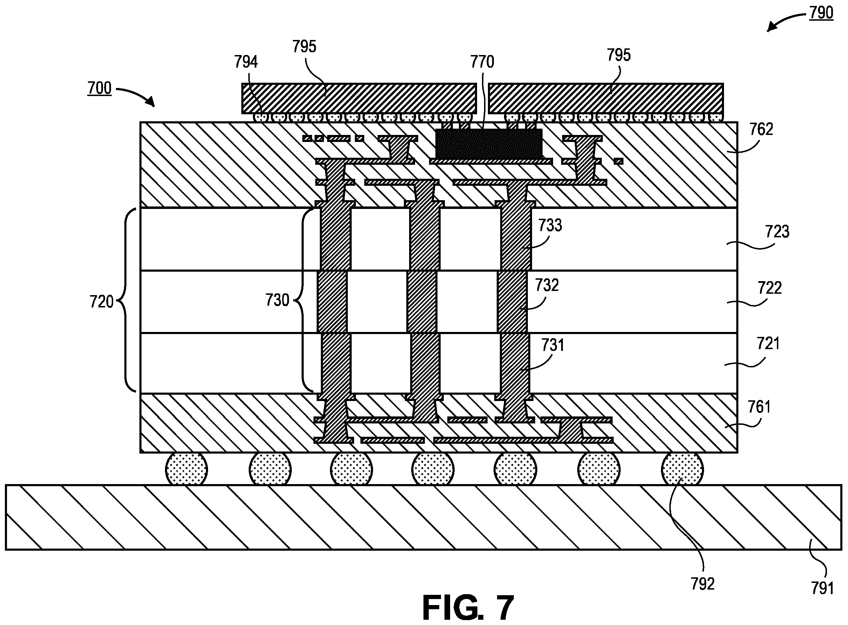

Referring now to Figure 7, a cross-sectional illustration of an electronic system 790 is shown, in accordance with an embodiment. In an embodiment, the electronic system 790 may comprise a board 791, such as a printed circuit board (PCB). In an embodiment, the board 791 may be coupled to a package substrate 700 by interconnects 792. The interconnects 792 may be solder balls or any other interconnect architecture.

In an embodiment, the package substrate 700 may comprise a core 720 with buildup layers 761 and 762 below and above the core 720. The core 720 may comprise a plurality of sub-core layers 721, 722, and 723. TGV portions 731, 732, and 733 may be provided in the sub-core layers 721, 722, and 723. The TGV portions 731, 732, and 733 may be stacked over each other to form TGVs 730. The TGVs 730 may have aspect ratios of approximately 10:1 or greater, or approximately 15:1 or greater. In some embodiments, centerlines of the TGV portions 731, 732, and 733 may be offset from each other. Additionally, while the TGV portions 731, 732, and 733 are shown as having vertical sidewalls, it is to be appreciated that sidewalls may be tapered or have an hourglass shaped cross-section.

In an embodiment, a bridge die 770 may be provided in the buildup layers 762. The bridge die 770 may electrically couple together a pair of dies 795. The dies 795 may be coupled to the package substrate 700 by interconnects 794, such as solder balls or any other first level interconnect (FLI) architecture. The dies 795 may be compute dies, memory dies, or any other type of die.

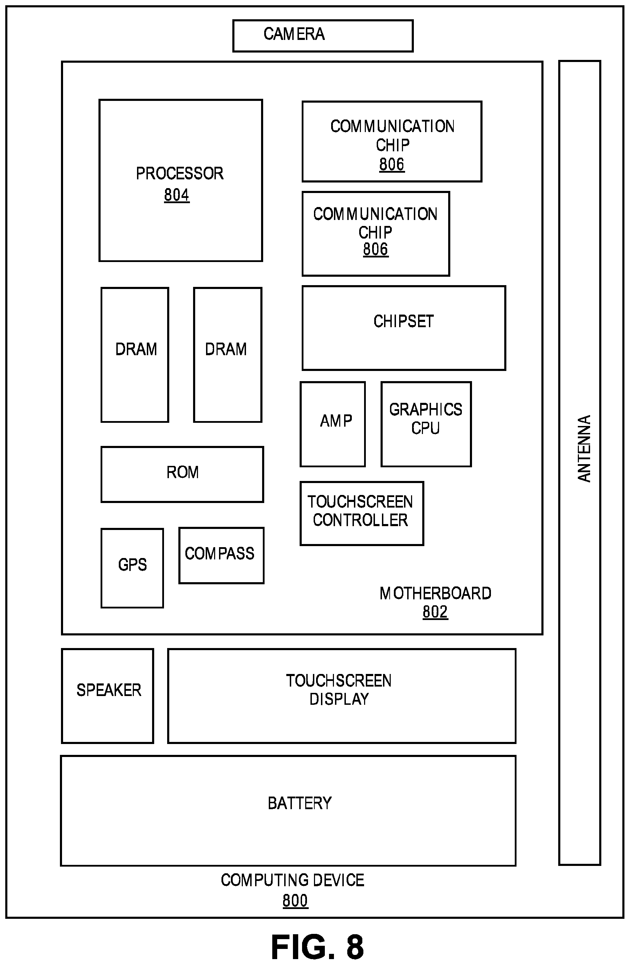

Figure 8 illustrates a computing device 800 in accordance with one implementation of the invention. The computing device 800 houses a board 802. The board 802 may include a number of components, including but not limited to a processor 804 and at least one communication chip 806. The processor 804 is physically and electrically coupled to the board 802. In some implementations the at least one communication chip 806 is also physically and electrically coupled to the board 802. In further implementations, the communication chip 806 is part of the processor 804.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. In some implementations of the invention, the integrated circuit die of the processor may be part of an electronic package that comprises a package substrate with a glass core fabricated from a plurality of sub-core layers, in accordance with embodiments described herein. The term "processor" may refer to any device or portion of a device that processes electronic data from registers and/or memory to transform that electronic data into other electronic data that may be stored in registers and/or memory.

The communication chip 806 also includes an integrated circuit die packaged within the communication chip 806. In accordance with another implementation of the invention, the integrated circuit die of the communication chip may be part of an electronic package that comprises a package substrate with a glass core fabricated from a plurality of sub-core layers, in accordance with embodiments described herein.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.

Example 1: a package substrate; comprising a core, wherein the core comprises: a first sub-core, wherein the first sub-core comprises a glass and a first through glass via (TGV); and a second sub-core, wherein the second sub-core comprises the glass and a second TGV, wherein the first TGV directly contacts the second TGV.

Example 2: the package substrate of Example 1, wherein the first sub-core is hybrid bonded to the second sub-core.

Example 3: the package substrate of Example 2, wherein there is a seam visible at the interface between the first TGV and the second TGV.

Example 4: the package substrate of Example 2, wherein there is no seam visible between the glass of the first sub-core and the glass of the second sub-core.

Example 5: the package substrate of Examples 1-4, wherein a centerline of the first TGV is offset from a centerline of the second TGV.

Example 6: the package substrate of Example 5, wherein the offset is up to two microns.

Example 7: the package substrate of Examples 1-6, wherein sidewalls of the first TGV are tapered to form a first end that is wider than a second end, and wherein sidewalls of the second TGV are tapered to form a third end that is wider than a fourth end.

Example 8: the package substrate of Example 7, wherein the first TGV and the second TGV are oriented so that the second end contacts the fourth end.

Example 9: the package substrate of Example 7, wherein the first TGV and the second TGV are oriented so that the first end contacts the third end.

Example 10: the package substrate of Examples 1-9, wherein the first TGV and the second TGV have hourglass shaped cross-sections.

Example 11: the package substrate of Examples 1-10, wherein an aspect ratio (height:width) of the first TGV is up to 5:1, and wherein an aspect ratio of the second TGV is up to 5:1.

Example 12: the package substrate of Example 11, wherein a thickness of the first sub-core is up to 500 microns, and wherein a thickness of the second sub-core is up to 500 microns.

Example 13: the package substrate of Examples 1-12, further comprising dielectric buildup layers over and under the core.

Example 14: a package substrate, comprising: first buildup layers; a core over the first buildup layers, wherein the core comprises a glass; a through glass via (TGV) through the core, wherein the TGV has an aspect ratio (height:width) of approximately 5:1 or greater, and wherein the TGV has at least one visible seam; and second buildup layers over the core.

Example 15: the package substrate of Example 14, wherein the visible seam includes a first grain direction on a first side and a second grain direction on a second side, wherein the first grain direction is different than the second grain direction.

Example 16: the package substrate of Example 14 or Example 15, wherein the glass does not include any visible seams through its thickness.

Example 17: the package substrate of Examples 14-16, wherein the aspect ratio is 10:1 or greater.

Example 18: the package substrate of Examples 14-17, further comprising a fiducial mark on the core.

Example 19: the package substrate of Examples 14-18, wherein the TGV has a first portion with a first centerline and a second portion with a second centerline, and wherein the first centerline is offset from the second centerline.

Example 20: the package substrate of Example 19, wherein the offset is up to two microns.

Example 21: the package substrate of Example 19 or Example 20, wherein a first edge of the first portion nearest an edge of the glass is a first distance from the edge of the glass, and wherein a second edge of the second portion nearest the edge of the glass is a second distance from the edge of the glass, wherein the first distance is different than the second distance.

Example 22: the package substrate of Examples 19-21, wherein the first portion has an hourglass shaped cross-section, and wherein the second portion has an hourglass shaped cross-section.

Example 23: an electronic system, comprising: a board; a package substrate coupled to the board, wherein the package substrate comprises: first buildup layers; a core over the first buildup layers, wherein the core comprises glass; a through glass via (TGV) through the core, wherein the TGV comprises a first portion with a first centerline and a second portion with a second centerline, wherein the first centerline is offset from the second centerline; and second buildup layers over the core; and a die coupled to the package substrate.

Example 24: the electronic system of Example 23, wherein the TGV has an aspect ratio (height:width) of approximately 5:1 or greater.

Example 25: the electronic system of Example 23 or Example 24, further comprising: a fiducial mark on the core.

## Claims

1. A package substrate, comprising:
a core, wherein the core comprises:
a first sub-core, wherein the first sub-core comprises a glass and a first through glass via (TGV); and
a second sub-core, wherein the second sub-core comprises the glass and a second TGV, wherein the first TGV directly contacts the second TGV.

2. The package substrate of claim 1, wherein the first sub-core is hybrid bonded to the second sub-core.

3. The package substrate of claim 2, wherein there is a seam visible at the interface between the first TGV and the second TGV.

4. The package substrate of claim 2, wherein there is no seam visible between the glass of the first sub-core and the glass of the second sub-core.

5. The package substrate of claim 1, 2, 3 or 4, wherein a centerline of the first TGV is offset from a centerline of the second TGV.

6. The package substrate of claim 5, wherein the offset is up to two microns.

7. The package substrate of claim 1, 2, 3, 4, 5 or 6, wherein sidewalls of the first TGV are tapered to form a first end that is wider than a second end, and wherein sidewalls of the second TGV are tapered to form a third end that is wider than a fourth end.

8. The package substrate of claim 7, wherein the first TGV and the second TGV are oriented so that the second end contacts the fourth end.

9. The package substrate of claim 7, wherein the first TGV and the second TGV are oriented so that the first end contacts the third end.

10. The package substrate of claim 1, 2, 3, 4, 5, 6, 7, 8 or 9, wherein the first TGV and the second TGV have hourglass shaped cross-sections.

11. The package substrate of claim 1, 2, 3, 4, 5, 6, 7, 8, 9 or 10, wherein an aspect ratio (height:width) of the first TGV is up to 5:1, and wherein an aspect ratio of the second TGV is up to 5:1.

12. The package substrate of claim 11, wherein a thickness of the first sub-core is up to 500 microns, and wherein a thickness of the second sub-core is up to 500 microns.

13. The package substrate of claim 1, 2, 3, 4, 5, 6, 7, 8, 9, 10, 11 or 12, further comprising dielectric buildup layers over and under the core.

14. A method of fabricating a package substrate, the method comprising:
forming a core, wherein the core comprises:
a first sub-core, wherein the first sub-core comprises a glass and a first through glass via (TGV); and
a second sub-core, wherein the second sub-core comprises the glass and a second TGV, wherein the first TGV directly contacts the second TGV.

15. The method of claim 14, wherein the first sub-core is hybrid bonded to the second sub-core.
